# EUROPEAN PATENT APPLICATION

(11) **EP 4 645 371 A1**
(43) Date of publication of application: **05.11.2025**
(21) Application number: 23911323.6
(22) Date of filing: 11.10.2023
(51) Int. Cl.: H01L 21/304, H01L 21/027

(54) **SUBSTRATE PROCESSING APPARATUS AND SUBSTRATE PROCESSING METHOD**

(30) Priority: 28.12.2022 JP 2022211299
(71) Applicant: SCREEN Holdings Co., Ltd., Kyoto-shi, Kyoto 602-8585 (JP)
(72) Inventor: IWAO, Michinori, Kyoto-shi, Kyoto 602-8585 (JP); IWAHATA, Shota, Kyoto-shi, Kyoto 602-8585 (JP); KAMON, Hiroaki, Kyoto-shi, Kyoto 602-8585 (JP)
(74) Representative: Kilian Kilian & Partner mbB
(86) International application number: PCT/JP2023/036848
(87) International publication number: WO 2024/142539

(57) **Abstract**

Substrate treatment is performed while suppressing decrease in oxidizing power of electrolytic sulfuric acid. A substrate treatment device includes a substrate treatment unit that treats a substrate using a treatment liquid containing electrolytic sulfuric acid, a supply tank that stores the treatment liquid to be supplied to the substrate treatment unit, a temperature increasing unit that increases a temperature of the treatment liquid by mixing imparted water with the treatment liquid supplied from the supply tank in the substrate treatment unit, a generation unit that generates the treatment liquid by electrolysis and supplies the generated treatment liquid to the supply tank, and a collection unit that collects a treated liquid which is the treatment liquid used in the substrate treatment unit and supplies the treated liquid to the generation unit.

## Description

### TECHNICAL FIELD

The technology disclosed in the present specification relates to a substrate treatment technology. Examples of a substrate to be treated include a semiconductor wafer, a glass substrate for a liquid crystal display device, a substrate for a flat panel display (FPD) such as an organic electroluminescence (EL) display device, a substrate for an optical disk, a substrate for a magnetic disk, a substrate for a magneto-optical disk, a glass substrate for a photomask, a ceramic substrate, a substrate for a field emission display (FED), a substrate for a solar cell, and the like.

### BACKGROUND ART

In related art, a mixed solution of sulfuric acid and hydrogen peroxide water (SPM), or the like, has been used as a treatment liquid for substrate treatment (see, for example, Patent Document 1). The SPM is a treatment liquid that generates oxidizing force by mixing hydrogen peroxide water with sulfuric acid and is mainly used for substrate treatment such as removal of a resist formed on an upper surface of a substrate.

### PRIOR ART DOCUMENT

### PATENT DOCUMENT

Patent Document 1: Japanese Patent Application Laid-Open No. 2018-163977

### SUMMARY

### PROBLEM TO BE SOLVED BY THE INVENTION

On the other hand, instead of using an SPM that generates a large amount of waste liquid as a treatment liquid, electrolytic sulfuric acid can be used as a treatment liquid for substrate treatment.

However, if a period during which the electrolytic sulfuric acid is maintained at a high temperature for use in substrate treatment becomes long, there is a problem that oxidizing power of the electrolytic sulfuric acid decreases due to autolysis.

The technology disclosed in the present specification has been made in view of the problem as described above, and is a technology for performing substrate treatment while suppressing decrease in oxidizing power of electrolytic sulfuric acid.

### MEANS TO SOLVE THE PROBLEM

A substrate treatment device according to a first aspect of the technology disclosed in the present specification includes: a substrate treatment unit that treats a substrate using a treatment liquid containing electrolytic sulfuric acid; a supply tank that stores the treatment liquid to be supplied to the substrate treatment unit; a temperature increasing unit that increases a temperature of the treatment liquid by mixing imparted water with the treatment liquid supplied from the supply tank in the substrate treatment unit; a generation unit that generates the treatment liquid by electrolysis and supplies the generated treatment liquid to the supply tank; and a collection unit that collects a treated liquid that is the treatment liquid used in the substrate treatment unit and supplies the treated liquid to the generation unit.

A substrate treatment device according to a second aspect of the technology disclosed in the present specification relates to the substrate treatment device according to the first aspect, and further includes a first circulation path that returns, to the supply tank, the treatment liquid supplied from the supply tank, the substrate treatment unit includes a discharge nozzle that discharges the treatment liquid branched and supplied from the first circulation path to the substrate, the discharge nozzle includes a discharge path that discharges the treatment liquid supplied to the substrate, and a second circulation path that branches from the discharge path and returns the treatment liquid to the supply tank, and the temperature increasing unit mixes the imparted water with the treatment liquid on a downstream side of a point at which the second circulation path branches, in the discharge path.

A substrate treatment device according to a third aspect of the technology disclosed in the present specification relates to the substrate treatment device according to the second aspect, and further includes a second temperature adjustment unit that adjusts the temperature of the treatment liquid to an electrolysis temperature that is a temperature for generating the treatment liquid by electrolysis in the first circulation path.

A substrate treatment device according to a fourth aspect of the technology disclosed in the present specification relates to a substrate treatment device according to any one of the first to third aspects, the generation unit includes a first electrolytic unit and a second electrolytic unit that generate the treatment liquid by electrolysis, and while the first electrolytic unit supplies the treatment liquid to the supply tank, the second electrolytic unit electrolyzes the treated liquid collected by the collection unit to generate the treatment liquid.

A substrate treatment device according to a fifth aspect of the technology disclosed in the present specification relates to the substrate treatment device according to any one of the first to fourth aspects, and the generation unit includes a first temperature adjustment unit that adjusts the temperature of the treated liquid and a temperature of the generated treatment liquid to an electrolysis temperature that is a temperature for generating the treatment liquid by electrolysis.

A substrate treatment device according to a sixth aspect of the technology disclosed in the present specification relates to the substrate treatment device according to any one of the first to fifth aspects, and the generation unit includes a first replenishing unit that replenishes the treatment liquid to be electrolyzed with the imparted water, and a second replenishing unit that replenishes the treatment liquid to be electrolyzed with sulfuric acid.

A substrate treatment method as a seventh aspect of the technology disclosed in the present specification is a substrate treatment method for treating a substrate using a treatment liquid containing electrolytic sulfuric acid, the substrate treatment method including: a step of storing the treatment liquid to be supplied to a substrate treatment unit in a supply tank; a step of increasing a temperature of the treatment liquid by mixing imparted water with the treatment liquid supplied from the supply tank in the substrate treatment unit; a step of treating the substrate using the treatment liquid mixed with the imparted water in the substrate treatment unit; a step of collecting a treated liquid which is the treatment liquid used for treatment in the substrate treatment unit, and supplying the treated liquid to a generation unit; and a step of generating the treatment liquid from a liquid containing the treated liquid by electrolysis in the generation unit and supplying the generated treatment liquid to the supply tank.

### EFFECTS OF THE INVENTION

According to at least the first and seventh aspects of the technology disclosed in the present specification, by increasing the temperature of the electrolytic sulfuric acid contained in the treatment liquid immediately before being used for substrate treatment in the substrate treatment unit, it is possible to perform the substrate treatment while suppressing decrease in oxidizing power of the electrolytic sulfuric acid.

Further, objects, features, aspects, and advantages relating to the technique disclosed in the present specification will be more apparent from the following detailed description and the accompanying drawings.

### BRIEF DESCRIPTION OF DRAWINGS

[FIG. 1] is a view illustrating an example of a configuration of a substrate treatment device according to an embodiment.
[FIG. 2] is a view conceptually illustrating an example of a configuration of a control unit for which an example is illustrated in FIG. 1.
[FIG. 3] is a view schematically illustrating an example of a treatment unit and related components in the substrate treatment device according to the embodiment.
[FIG. 4] is a cross-sectional view illustrating an example of an internal structure of a discharge nozzle.
[FIG. 5] is a view illustrating an example of a configuration of the substrate treatment device in a circulation state of the discharge nozzle.
[FIG. 6] is a view illustrating an example of a configuration of the substrate treatment device in a discharge state of the discharge nozzle.

### DESCRIPTION OF EMBODIMENTS

Hereinafter, embodiments will be described with reference to the accompanying drawings. In the following embodiments, detailed features, and the like, are also indicated for the description of the technology, but they are merely examples, and not all of them are necessarily essential features in order to enable the embodiments to be carried out.

Note that the drawings are schematically illustrated, and omission of a component, simplification of a configuration, or the like, is appropriately made in the drawings for convenience of description. In addition, a mutual relationship of sizes and positions of components, and the like, illustrated in different drawings is not necessarily accurately described, and can be appropriately changed. In addition, hatching may be applied to a drawing such as a plan view that is not a cross-sectional view in order to facilitate understanding of the content of the embodiments.

Furthermore, in the following description, similar components are denoted by the same reference numerals, and names and functions thereof are also similar. Thus, detailed description thereof may be omitted in order to avoid duplication.

In addition, in the description described in the present specification, in a case where a certain component is described as "comprising", "including", "having", or the like, the expression is not an exclusive expression excluding the presence of other components unless otherwise specified.

In addition, in the description described in the present specification, even if ordinal numbers such as "first" or "second" are used, these terms are used for convenience to facilitate understanding of the content of the embodiments, and the content of the embodiments is not limited to the order, or the like, that can be caused by these ordinal numbers.

Furthermore, in the description described in the present specification, even if terms meaning specific positions or directions such as "upper", "lower", "left", "right", "side", "bottom", "front", or "back" are used, these terms are used for convenience to facilitate understanding of the content of the embodiments, and are not related to the positions or directions when the embodiments are actually implemented.

Furthermore, in the description described in the present specification, the description of "upper surface of...", "lower surface of...", or the like, includes a state in which another component is formed on the upper surface or the lower surface of a target component in addition to the upper surface itself or the lower surface itself of the target component. In other words, for example, in a case where it is described as "B provided on the upper surface of A", it does not prevent another component "C" from being interposed between A and B.

### <Embodiment>

Hereinafter, a substrate treatment device and a substrate treatment method according to the present embodiment will be described.

### <Configuration of substrate treatment device>

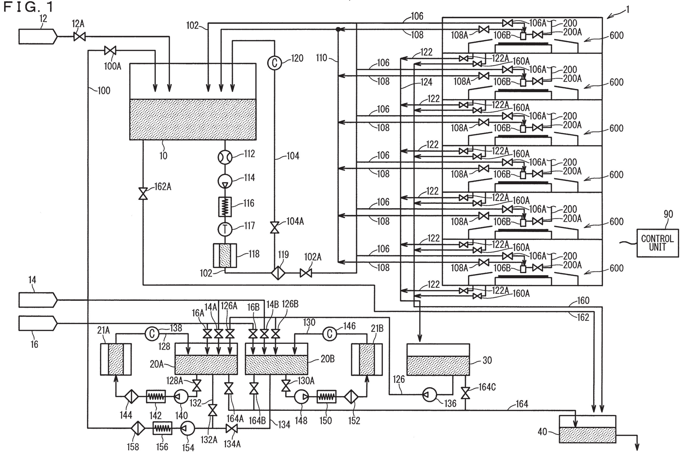

FIG. 1 is a view illustrating an example of a configuration of a substrate treatment device according to the present embodiment. As illustrated in FIG. 1, a substrate treatment device 1 includes a plurality of treatment units 600, a supply tank 10, a generation tank 20A and a generation tank 20B, an electrolytic cell 21A and an electrolytic cell 21B, a collection tank 30, a waste liquid tank 40 that discharges a treatment liquid, or the like, and a control unit 90.

The treatment unit 600 treats a substrate using a supplied treatment liquid. A detailed configuration of the treatment unit 600 will be described later. Note that the number of the treatment units 600 is not limited to the number illustrated in FIG. 1.

The supply tank 10 stores the treatment liquid supplied from the generation tank 20A or the generation tank 20B via a supply pipe 100. Then, the supply tank 10 supplies the treatment liquid to the treatment unit 600. Pure water (DIW), hydrogen peroxide water, or ozone water is supplied from a pure water supply source 12 to the supply tank 10. A flow rate of pure water, or the like, supplied from the pure water supply source 12 can be adjusted by the control of a valve 12A by the control unit 90. Note that the pure water supply source 12 does not have to be provided.

A pipe for supplying the treatment liquid from the supply tank 10 includes a circulation pipe 102 that is connected to the supply tank 10 and circulates the treatment liquid through the supply tank 10, a measurement pipe 104 that branches from the circulation pipe 102 and returns the treatment liquid to the supply tank 10, a supply pipe 106 that branches from the circulation pipe 102 and supplies the treatment liquid to each treatment unit 600, a return pipe 108 that branches at a downstream end portion of each supply pipe 106 and returns the treatment liquid to the supply tank 10 side, and a circulation pipe 110 that returns the treatment liquid joined from each return pipe 108 to the supply tank 10.

A flow meter 112 that measures a flow rate of the treatment liquid, a pump 114 that causes the treatment liquid to flow, a heater 116 that heats the treatment liquid, a thermometer 117 that measures a temperature of the treatment liquid, and an electrolytic cell 118 that electrolyzes the treatment liquid are provided on an upstream side of a position at which the measurement pipe 104 branches, in the circulation pipe 102. Note that the electrolytic cell 118 does not have to be provided in a case where autolysis of the treatment liquid is sufficiently suppressed. In addition, the heater may be replaced with a mechanism capable of temperature adjustment including cooling, and is not limited to the case of heating. The same applies to the heaters described below.

The measurement pipe 104 is provided with a concentration meter 120 for measuring concentration of the treatment liquid flowing through the measurement pipe 104. In a case where the concentration of the treatment liquid measured by the concentration meter 120 is higher than desired concentration, pure water, or the like, is supplied from the pure water supply source 12 to the supply tank 10 under the control of the control unit 90, whereby the concentration of the treatment liquid can be reduced. In a case where the concentration of the treatment liquid measured by the concentration meter 120 is lower than the desired concentration, the treatment liquid is electrolyzed in the electrolytic cell 118 under the control of the control unit 90, and at the same time, water is electrolyzed, whereby the concentration of the treatment liquid can be increased. Note that water generated by electrolysis can also be used as imparted water.

On the downstream side of a position at which the measurement pipe 104 branches, in the circulation pipe 102, a filter 119 that removes particles, and the like, in the treatment liquid and a valve 102A capable of adjusting a flow rate of the treatment liquid circulated in the circulation pipe 102 under the control of the control unit 90, are provided.

The supply pipe 106 is provided with a valve 106A capable of adjusting a flow rate of the treatment liquid flowing through the supply pipe 106 under the control of the control unit 90. The treatment liquid having a partial flow rate of the treatment liquid flowing through the circulation pipe 102 flows through the supply pipe 106.

The return pipe 108 is provided with a valve 108A capable of adjusting a flow rate of the treatment liquid flowing through the return pipe 108 under the control of the control unit 90.

Further, a portion where the return pipe 108 branches from the supply pipe 106 is provided in the discharge nozzle 106B of the treatment unit 600, and the discharge nozzle 106B is further connected with a mixing pipe 200 that mixes imparted water which is pure water (DIW), hydrogen peroxide water, or ozone water with the treatment liquid in the supply pipe 106. The mixing pipe 200 is provided with a valve 200A capable of adjusting a flow rate of the imparted water flowing in the mixing pipe 200 under the control of the control unit 90.

The imparted water supplied to the mixing pipe 200 may be supplied from a pure water supply source 12 or may be supplied from a supply source separately prepared.

A pipe for collecting the treatment liquid from the treatment unit 600 includes a waste liquid pipe 122 that is connected to each treatment unit 600 and discharges the treatment liquid (treated liquid) used for substrate treatment, a collection pipe 124 that supplies the treated liquid joined from each waste liquid pipe 122 to the collection tank 30, a collection pipe 126 that is connected to the collection tank 30 and supplies the treated liquid to the generation tank 20A or the generation tank 20B, a circulation pipe 128 that circulates the treatment liquid between the generation tank 20A and the electrolytic cell 21A, a circulation pipe 130 that circulates the treatment liquid between the generation tank 20B and the electrolytic cell 21B, a supply pipe 132 that joins the treatment liquid from the generation tank 20A to the supply pipe 100, and a supply pipe 134 that joins the treatment liquid from the generation tank 20B to the supply pipe 100. The waste liquid pipe 122 is provided with a valve 122A capable of adjusting a flow rate of the waste liquid from the treatment unit 600 under the control of the control unit 90.

Here, a plurality of the collection tanks 30 may be provided in parallel. In other words, it is also possible to lengthen a period from when the treated liquid from the collection pipe 124 is selectively supplied to the plurality of collection tanks until when the treated liquid is supplied from the collection tanks to the generation tank.

The collection pipe 126 is provided with a pump 136 for feeding the treated liquid stored in the collection tank 30 to the generation tank 20A or the generation tank 20B, a valve 126A capable of adjusting a flow rate of the treated liquid to be fed to the generation tank 20A under the control of the control unit 90, and a valve 126B capable of adjusting a flow rate of the treated liquid to be fed to the generation tank 20B under the control of the control unit 90.

The circulation pipe 128 is provided with a valve 128A for adjusting a flow rate of the treatment liquid flowing through the circulation pipe 128 under the control of the control unit 90, a concentration meter 138 for measuring the concentration of the treatment liquid flowing through the circulation pipe 128, a pump 140 for feeding the treatment liquid flowing through the circulation pipe 128, a heater 142 that heats the treatment liquid, and a filter 144 that removes particles, and the like, in the treatment liquid.

The circulation pipe 130 is provided with a valve 130A for adjusting the flow rate of the treatment liquid flowing through the circulation pipe 130 under the control of the control unit 90, a concentration meter 146 for measuring the concentration of the treatment liquid flowing through the circulation pipe 130, a pump 148 for feeding the treatment liquid flowing through the circulation pipe 130, a heater 150 that heats the treatment liquid, and a filter 152 that removes particles, and the like, in the treatment liquid.

The supply pipe 132 is provided with a valve 132A capable of adjusting a flow rate of the treatment liquid flowing through the supply pipe 132 under the control of the control unit 90.

The supply pipe 134 is provided with a valve 134A capable of adjusting a flow rate of the treatment liquid flowing through the supply pipe 134 under the control of the control unit 90.

The supply pipe 100 is provided with a pump 154 for feeding the treatment liquid flowing through the supply pipe 100, a heater 156 that heats the treatment liquid, a filter 158 that removes particles, and the like, in the treatment liquid, and a valve 100A for adjusting the flow rate of the treatment liquid flowing through the supply pipe 100 under the control of the control unit 90.

Further, pure water (DIW), hydrogen peroxide water, or ozone water is supplied from the pure water supply source 14 to the generation tank 20A and the generation tank 20B. A flow rate of pure water, or the like, to be supplied from the pure water supply source 14 to the generation tank 20A can be adjusted by the control of the valve 14A by the control unit 90. A flow rate of pure water, or the like, to be supplied from the pure water supply source 14 to the generation tank 20B can be adjusted by the control of the valve 14B by the control unit 90. Note that the pure water supply source 14 does not have to be provided.

Sulfuric acid (H₂SO₄) is supplied from the sulfuric acid supply source 16 to the generation tank 20A and the generation tank 20B. A flow rate of the sulfuric acid to be supplied from the sulfuric acid supply source 16 to the generation tank 20A can be adjusted by the control of the valve 16A by the control unit 90. A flow rate of the sulfuric acid to be supplied from the sulfuric acid supply source 16 to the generation tank 20B can be adjusted by the control of the valve 16B by the control unit 90. Note that the sulfuric acid supply source 16 does not have to be provided.

A pipe for discharging the treatment liquid and the treated liquid includes a waste liquid pipe 160 for discharging the treated liquid from each treatment unit 600 to the waste liquid tank 40, a waste liquid pipe 162 for discharging the treatment liquid from the supply tank 10 to the waste liquid tank 40, and a waste liquid pipe 164 for discharging the treatment liquid or the treated liquid from the generation tank 20A, the generation tank 20B, and the collection tank 30 to the waste liquid tank 40. The waste liquid pipe 160 is provided with a valve 160A that adjusts a flow rate of the waste liquid from the treatment unit 600 under the control of the control unit 90. The waste liquid pipe 162 is provided with a valve 162A that adjusts a flow rate of the waste liquid from the supply tank 10 under the control of the control unit 90. The waste liquid pipe 164 is provided with a valve 164A that adjusts the flow rate of the waste liquid from the generation tank 20A under the control of the control unit 90, a valve 164B that adjusts the flow rate of the waste liquid from the generation tank 20B under the control of the control unit 90, and a valve 164C that adjusts the flow rate of the waste liquid from the collection tank 30 under the control of the control unit 90.

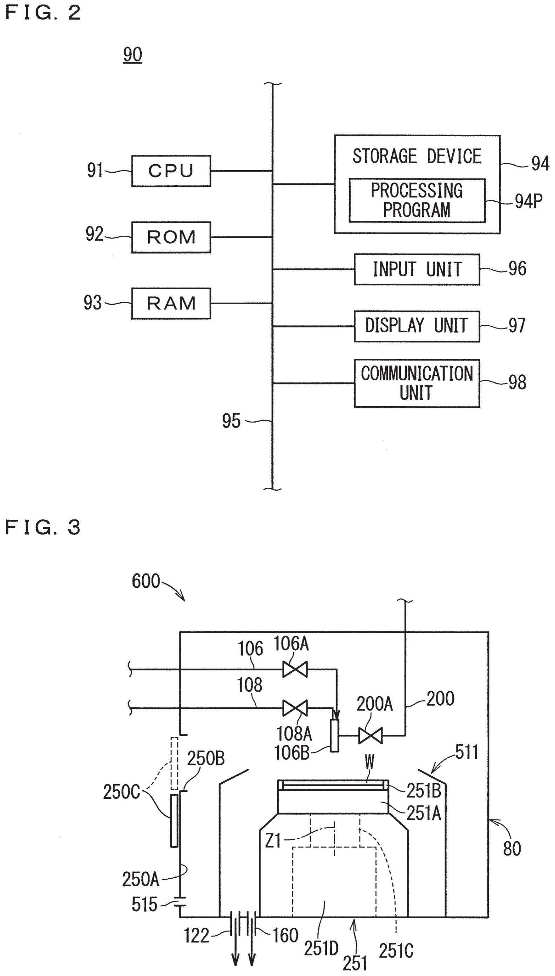

FIG. 2 is a view conceptually illustrating an example of a configuration of the control unit 90 for which an example is illustrated in FIG. 1. The control unit 90 may include a general computer having an electric circuit. Specifically, the control unit 90 includes a central processing unit (CPU) 91, a read only memory (ROM) 92, a random access memory (RAM) 93, a storage device 94, an input unit 96, a display unit 97, a communication unit 98, and a bus line 95 connecting these units to each other.

The ROM 92 stores a basic program. The RAM 93 is used as a work area when the CPU 91 performs predetermined processing. The storage device 94 includes a non-volatile storage device such as a flash memory or a hard disk device. The input unit 96 includes various switches, a touch panel, or the like, and receives an input setting instruction such as a treatment recipe from an operator. The display unit 97 includes, for example, a liquid crystal display device, a lamp, and the like, and displays various types of information under the control of the CPU 91. The communication unit 98 has a data communication function via a local area network (LAN), or the like.

In the storage device 94, a plurality of modes for controlling each component in the substrate treatment device 1 of FIG. 1 is set in advance. By the CPU 91 executing a processing program 94P, one of the plurality of modes is selected, and each component is controlled in the mode. Note that the processing program 94P may be stored in a recording medium. By using this recording medium, the processing program 94P can be installed in the control unit 90. In addition, some or all of the functions to be executed by the control unit 90 are not necessarily implemented by software, and may be implemented by hardware such as a dedicated logic circuit.

FIG. 3 is a view schematically illustrating an example of the treatment unit 600 and related components in the substrate treatment device according to the present embodiment. Note that while FIG. 3 illustrates an example of the configuration of the treatment unit 600 arranged downstream of one supply pipe 106 in FIG. 1, the configuration of the treatment unit 600 arranged downstream of the other supply pipes 106 is also similar to the case illustrated in FIG. 3.

As illustrated in FIG. 3 as an example, the treatment unit 600 includes a box-shaped chamber 80 having an internal space, a spin chuck 251 that rotates a substrate W around a vertical rotation axis Z1 passing through a central portion of the substrate W while holding one substrate W in a horizontal posture in the chamber 80, and a tubular treatment cup 511 surrounding the spin chuck 251 around the rotation axis Z1 of the substrate W.

The chamber 80 is surrounded by a box-shaped wall 250A. An opening 250B for carrying the substrate W into and out of the chamber 80 is formed in the wall 250A.

The opening 250B is opened and closed by a shutter 250C. The shutter 250C is lifted or lowered between a closed position (indicated by a two-dot chain line in FIG. 3) at which the opening 250B is covered and an open position (indicated by a solid line in FIG. 3) at which the opening 250B is opened by a shutter lifting and lowering mechanism (not illustrated here).

As illustrated in FIG. 3, the spin chuck 251 includes a disk-shaped spin base 251A provided to face the substrate W in a horizontal posture, a plurality of chuck pins 251B protruding upward from an outer peripheral portion of an upper surface of the spin base 251A and clamping a peripheral portion of the substrate W, a rotation shaft 251C extending downward from a central portion of the spin base 251A, and a spin motor 251D rotating the rotation shaft 251C to rotate the substrate W attracted to the spin base 251A.

Note that the spin chuck 251 is not limited to a clamping type chuck illustrated in the example in FIG. 3, and may be, for example, a vacuum suction type chuck including a spin base that vacuum-sucks the lower surface of the substrate W.

A nozzle (for example, a nozzle that discharges another chemical liquid, a nozzle that discharges a rinse liquid, or the like) for discharging a liquid for another use may be connected to the treatment unit 600.

Further, as illustrated in the example in FIG. 3, a discharge nozzle 106B that discharges the treatment liquid is connected to a distal end of the supply pipe 106 connected to the treatment unit 600. The discharge nozzle 106B discharges the treatment liquid toward a predetermined portion (for example, the spin base 251A) inside the chamber 80.

The treatment cup 511 is provided so as to surround the periphery of the spin chuck 251, and is lifted and lowered in the vertical direction by a lifting and lowering mechanism (motor, cylinder, or the like) (not illustrated). An upper portion of the treatment cup 511 is lifted and lowered between an upper position where the upper end thereof is above the substrate W held by the spin base 251A and a lower position where the upper end thereof is below the substrate W.

The treatment liquid scattered outward from the upper surface of the substrate W is received by an inner surface of the treatment cup 511. Then, the treatment liquid received by the treatment cup 511 is appropriately discharged to the outside of the chamber 80 via the waste liquid pipe 122 and the waste liquid pipe 160 provided at the bottom of the chamber 80 and inside the treatment cup 511. In addition, an atmosphere in the treatment cup 511 is exhausted by a cup exhaust mechanism (not illustrated).

Further, an exhaust port 515 is provided in a side portion of the chamber 80. An atmosphere in the chamber 80 is appropriately discharged to the outside of the chamber 80 through the exhaust port 515.

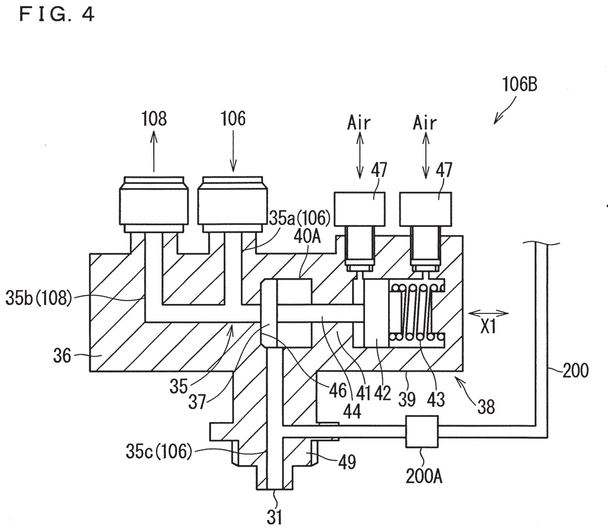

FIG. 4 is a cross-sectional view illustrating an example of an internal structure of the discharge nozzle 106B.

The discharge nozzle 106B includes a main body 36 in which a flow path 35 that guides a treatment liquid is formed, a valve body 37 that opens and closes the flow path 35, a pneumatic actuator 38 that moves the valve body 37 forward and backward in an axial direction X1 to open and close the flow path 35, a mixing pipe 200 joined to a position (flow path 35c) downstream of the valve body 37 in the flow path 35, and a discharge port 31.

The main body 36 includes a cylinder 39 constituting the pneumatic actuator 38, a valve chamber 40A that moves the valve body 37 forward and backward, a flow path 35a communicating with the supply pipe 106 and reaching the valve chamber 40A, a flow path 35b connected to the flow path 35a at a position upstream of the valve chamber 40A of the flow path 35a and communicating with the return pipe 108, and a flow path 35c reaching the discharge port 31 from the valve chamber 40A.

The cylinder 39 and the valve chamber 40A are arranged in the axial direction X1. The cylinder 39 and the valve chamber 40A are separated from each other by a partition wall 41. The flow path 35a and the flow path 35c correspond to part of the supply pipe 106 that guides the treatment liquid supplied from the supply tank 10 toward the discharge port 31. Further, the flow path 35b corresponds to part of the return pipe 108 that returns the treatment liquid to the supply tank 10.

The pneumatic actuator 38 includes a cylinder 39, a piston 42, a spring 43, and a rod 44. The cylinder 39 is separated by the piston 42 into a front chamber on the partition wall 41 side and a rear chamber on the opposite side in the axial direction X1 across the piston 42. A joint 47 is connected to the main body 36 for connecting a tube that transmits air pressure separately to the front chamber and the rear chamber of the cylinder 39. The piston 42 is moved forward and backward in the cylinder 39 along the axial direction X1 by transmitting air pressure to either the front chamber or the rear chamber of the cylinder 39 via the tube and the joint 47.

The spring 43 is interposed between the piston 42 and the main body 36 on the rear chamber side of the cylinder 39 to press the piston 42 toward the partition wall 41.

A base portion of the rod 44 is connected to the piston 42, and a distal end portion thereof penetrates the partition wall 41 and protrudes to the valve chamber 40A. A valve body 37 is connected to a distal end portion of the rod 44 protruding to the valve chamber 40A. The valve body 37 is formed in a disk shape, and is connected to a distal end portion of the rod 44 so that a radial direction is orthogonal to the axial direction X1. When the piston 42 is moved forward and backward in the cylinder 39 along the axial direction X1, the valve body 37 is moved forward and backward in the axial direction X1 in the valve chamber 40A via the rod 44.

The valve chamber 40A includes an annular valve seat surface 46 facing the partition wall 41 and orthogonal to the axial direction X1, and a flow path 35a is concentrically opened at the center position of the valve seat surface 46. The flow path 35c is opened to the side of the valve chamber 40A in the forward and backward direction (axial direction X1) of the valve body 37.

The main body 36 has a discharge port 31 formed at a distal end, and includes a cylindrical portion 49 protruding downward from the lower surface of the nozzle head 26. Further, the mixing pipe 200 is inserted from the side of the cylindrical portion 49, and the mixing pipe 200 is connected to the flow path 35c at a position downstream of the valve chamber 40A.

In a state where no air pressure is applied to either the front chamber or the rear chamber of the cylinder 39 and the pneumatic actuator 38 is not operated, the piston 42 is pressed by the spring 43 to a forward position in the cylinder 39, that is, a position close to the partition wall 41 side as illustrated in the example in FIG. 4, so that the valve body 37 is brought into contact with the valve seat surface 46 in the valve chamber 40A, and the opening of the flow path 35a is closed.

Thus, a space between the flow path 35a and the flow path 35c is closed, and the treatment liquid supplied from the supply tank 10 through the supply pipe 106 and the flow path 35a is returned to the supply tank 10 through the flow path 35b and the return pipe 108 (circulation state).

In this circulation state, if the air pressure is transmitted to the front chamber of the cylinder 39 to move the piston 42 backward in a rear chamber direction of the cylinder 39 against pressing force of the spring 43, the valve body 37 is separated from the valve seat surface 46 in the valve chamber 40A, and the opening of the flow path 35a is released to the valve chamber 40A. Thus, the flow path 35a and the flow path 35c are connected via the valve chamber 40A, and the treatment liquid supplied from the supply tank 10 through the supply pipe 106 and the flow path 35a is discharged from the discharge port 31 through the flow path 35c (discharge state).

In this discharge state, when transmission of the air pressure to the front chamber of the cylinder 39 is stopped, and instead, the air pressure is transmitted to the rear chamber of the cylinder 39 to move the piston 42 forward in the front chamber direction of the cylinder 39, that is, in the direction approaching the partition wall 41 together with the pressing force of the spring 43, the valve body 37 is brought into contact with the valve seat surface 46 in the valve chamber 40A, and the opening of the flow path 35a is closed. Thus, the space between the flow path 35a and the flow path 35c is closed, and the treatment liquid supplied from the supply tank 10 through the supply pipe 106 and the flow path 35a returns to the circulation state where the treatment liquid is returned to the supply tank 10 through the flow path 35b and the return pipe 108.

In the discharge state described above, if the valve 200A is opened and the imparted water is mixed with the treatment liquid from the mixing pipe 200, the temperature of the treatment liquid containing electrolytic sulfuric acid is increased by reaction heat. Specifically, the temperature of the treatment liquid is increased to a temperature (treatment temperature) at the time of being used for substrate treatment.

### <Operation of substrate treatment device>

Next, operation of the substrate treatment device will be described. A substrate treatment method by the substrate treatment device according to the present embodiment includes a step of discharging the treatment liquid onto the substrate W conveyed to the treatment unit 600 to perform substrate treatment, a step of cleaning the substrate W subjected to the substrate treatment, a step of rotating and drying the cleaned substrate W, and a step of carrying the dried substrate W out of the treatment unit 600.

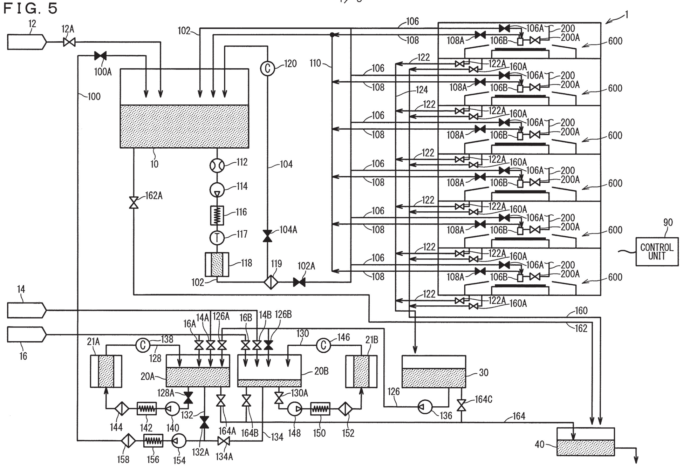

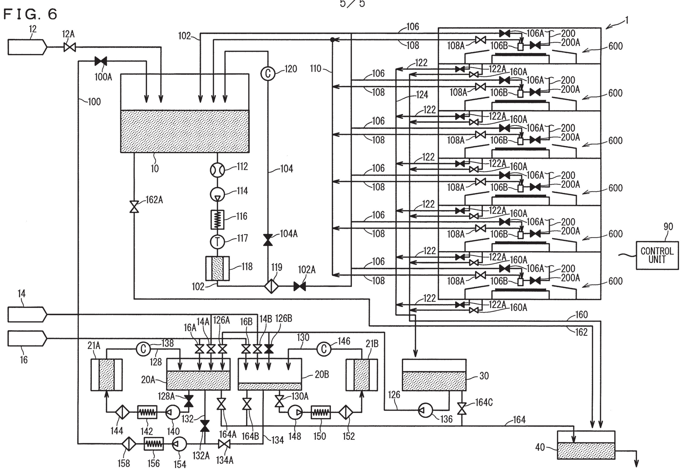

Hereinafter, substrate treatment included in the operation of the substrate treatment device will be described with reference to FIGS. 5 and 6. Here, FIG. 5 is a view illustrating an example of a configuration of the substrate treatment device in a circulation state of the discharge nozzle 106B. Further, FIG. 6 is a view illustrating an example of a configuration of the substrate treatment device in a discharge state of the discharge nozzle 106B. In FIGS. 5 and 6, the valve in the open state is illustrated in black. Note that the operation described below is performed by the control unit 90 controlling the operation of each component (such as a pump, a heater, a valve or a spin motor) in the substrate treatment device 1.

First, sulfuric acid (H₂SO₄) is circulated between the generation tank 20A and the electrolytic cell 21A through the circulation pipe 128 to generate a treatment liquid containing electrolytic sulfuric acid. Here, the electrolytic sulfuric acid refers to a persulfuric acid (peroxodisulfuric acid, that is, H₂S₂O₈). Persulfuric acid has stronger oxidizing power than caloric acid (H₂SO₅) at the same temperature.

Sulfuric acid is appropriately supplied from the sulfuric acid supply source 16 to the generation tank 20A by the control of the valve 16A by the control unit 90. Pure water (DIW), or the like, is appropriately supplied from the pure water supply source 14 by the control of the valve 14A by the control unit 90. Further, as will be described later, the treated liquid is supplied from the collection tank 30 to the generation tank 20A by the control of the valve 126A by the control unit 90.

A temperature of the treatment liquid stored in the generation tank 20A is adjusted to, for example, equal to or lower than 60°C by the heater 142 in the circulation pipe 128 in a state where the valve 128A is opened, particles, and the like, are appropriately removed by the filter 144, and the treatment liquid is fed to the electrolytic cell 21A by the pump 140. By adjusting the temperature of the treatment liquid to equal to or lower than 60°C (electrolysis temperature), a generation rate of electrolytic sulfuric acid increases in a case where sulfuric acid is electrolyzed. In addition, by adjusting the temperature of the treatment liquid to equal to or lower than 60°C, the electrolytic sulfuric acid is suppressed from being autolyzed into caloric acid (H₂SO₅) and OH radicals.

Then, sulfuric acid whose temperature has been adjusted in the electrolytic cell 21A is electrolyzed to generate a treatment liquid containing electrolytic sulfuric acid and sulfuric acid. Here, when sulfuric acid is electrolyzed, water molecules in the treatment liquid are also electrolyzed, and thus, the concentration of the treatment liquid increases as the sulfuric acid is electrolyzed. The concentration of the treatment liquid containing electrolytic sulfuric acid is measured by the concentration meter 138, and the control unit 90 controls a flow rate of the treatment liquid to be fed to the electrolytic cell 21A based on the measured concentration (that is, by the control of opening and closing of the valve 128A, the flow rate of the treatment liquid is increased in a case where the measured concentration is low, and the flow rate of the treatment liquid is decreased in a case where the measured concentration is high). Note that if the concentration of electrolytic sulfuric acid is decreased, generation efficiency of persulfuric acid increases.

The generation tank 20A has a redundant configuration with the generation tank 20B. Thus, as in the case of the generation tank 20A, sulfuric acid (H₂SO₄) is circulated between the generation tank 20B and the electrolytic cell 21B via the circulation pipe 130 to generate a treatment liquid containing electrolytic sulfuric acid.

To the generation tank 20B, sulfuric acid is appropriately supplied from the sulfuric acid supply source 16 by the control of the valve 16B by the control unit 90. Pure water (DIW), or the like, is appropriately supplied from the pure water supply source 14 by the control of the valve 14B by the control unit 90. Further, as will be described later, the treated liquid is supplied from the collection tank 30 to the generation tank 20B by the control of the valve 126B by the control unit 90.

A temperature of the treatment liquid stored in the generation tank 20B is adjusted to an electrolysis temperature (for example, equal to or lower than 60°C) by the heater 150 in the circulation pipe 130 in a state where the valve 130A is opened, particles, and the like, are appropriately removed by the filter 152, and the treatment liquid is fed to the electrolytic cell 21B by the pump 148.

Then, sulfuric acid whose temperature has been adjusted in the electrolytic cell 21B is electrolyzed to generate a treatment liquid containing electrolytic sulfuric acid and sulfuric acid. The concentration of the treatment liquid containing electrolytic sulfuric acid is measured by the concentration meter 146, and the control unit 90 adjusts the flow rate of the treatment liquid to be fed to the electrolytic cell 21B by the control of opening and closing of the valve 130A based on the measured concentration.

The generation tank 20A and the generation tank 20B can supply the treatment liquid to the supply tank 10 in a switchable manner. For example, as illustrated in the example in FIG. 5, while the valve 128A is opened to circulate the treatment liquid in the circulation pipe 128, the valve 132A is opened to supply the treatment liquid from the generation tank 20A to the supply tank 10, and during this time, the treated liquid from the collection tank 30 can be stored in the generation tank 20B by closing the valve 130A and the valve 134A. Alternatively, in a case where the concentration of the electrolytic sulfuric acid stored in the generation tank 20A does not reach the desired concentration, by closing the valve 132A while opening the valve 128A to continue circulation of the treatment liquid in the circulation pipe 128 to increase the concentration of the treatment liquid by electrolysis of sulfuric acid and opening the valve 130A and the valve 134A, the treatment liquid reaching the desired concentration circulated in the circulation pipe 130 can be supplied from the generation tank 20B to the supply tank 10. In other words, even while the treatment liquid is being generated in one generation tank (electrolytic cell), the treatment liquid can be continuously supplied from the other generation tank.

The temperature of the treatment liquid supplied from any (or both) generation tank is adjusted to, for example, equal to or lower than 60°C by the heater 156 in the supply pipe 100, particles, and the like, are appropriately removed by the filter 158, and the treatment liquid is fed to the supply tank 10 by the pump 154 via the valve 100A in the open state.

The supply tank 10 stores the treatment liquid supplied from the generation tank via the supply pipe 100. Further, pure water (DIW), or the like, is appropriately supplied from the pure water supply source 12 to the supply tank 10, so that the concentration of the treatment liquid is adjusted.

The temperature of the treatment liquid to be fed from the supply tank 10 through the circulation pipe 102 is adjusted by the heater 116 so that the temperature measured by the thermometer 117 in the circulation pipe 102 becomes, for example, equal to or lower than 60°C, particles, and the like, are appropriately removed by the filter 119, and the treatment liquid is fed again to the supply tank 10 by the pump 114. The control unit 90 grasps the substrate treatment to be performed by the treatment unit 600 with reference to the treatment recipe, and adjusts the flow rate of the treatment liquid circulating in the circulation pipe 102 by opening and closing the valve 102A, or the like, so that the flow rate of the treatment liquid measured by the flow meter 112 becomes a flow rate sufficient for the substrate treatment.

The measurement pipe 104 branching from the circulation pipe 102 is provided with a valve 104A that adjusts the flow rate under the control of the control unit 90 and the concentration meter 120. The control unit 90 performs control such as opening the valve 12A to supply pure water, or the like, from the pure water supply source 12 to the supply tank 10, or electrolysis of the treatment liquid in the electrolytic cell 118 to increase the concentration of the treatment liquid with reference to the concentration of the treatment liquid measured by the concentration meter 120.

On the downstream side of the circulation pipe 102, a supply pipe 106 branching into each treatment unit 600 is provided, and the treatment liquid can be appropriately supplied to the treatment unit 600 by opening the corresponding valve 106A under the control of the control unit 90.

In the circulation state of the discharge nozzle 106B (state in which the valve body 37 of FIG. 4 is in contact with the valve seat surface 46), the valve 106A and the valve 108A are opened, and the treatment liquid supplied from the circulation pipe 102 to the supply pipe 106 and further to the return pipe 108 joins the circulation pipe 110 and is returned to the supply tank 10. As described above, the treatment liquid flows into the discharge nozzle 106B in the supply pipe 106 and circulates, whereby the temperature change of the treatment liquid due to a temperature difference between the pipe and the treatment liquid can be suppressed when the treatment liquid is discharged to perform the substrate treatment. Note that the flow rate of the treatment liquid supplied through the return pipe 108 in the circulation state is preferably suppressed to a minimum flow rate for maintaining the temperature of the pipe.

In the discharge state of the discharge nozzle 106B (state in which the valve body 37 in FIG. 4 is separated from the valve seat surface 46), the valve 106A is opened while the valve 108A is closed, and the treatment liquid is discharged from the discharge port 31 of the discharge nozzle 106B toward the upper surface of the substrate W. Then, substrate treatment is performed.

Here, immediately before the treatment liquid is discharged from the discharge port 31, imparted water is mixed with the treatment liquid in the flow path 35c from the mixing pipe 200 in which the valve 200A is in the open state. If imparted water such as pure water is mixed with the treatment liquid containing electrolytic sulfuric acid, the temperature of the treatment liquid is increased by reaction heat, and reaches, for example, about 90°C.

The oxidizing power of the electrolytic sulfuric acid is increased by increasing the temperature of the electrolytic sulfuric acid with the imparted water, and the substrate treatment (for example, resist stripping treatment) can be performed with high efficiency using the treatment liquid without increasing the temperature by a heater, or the like. In addition, in a case where ozone water is mixed with electrolytic sulfuric acid as the imparted water, oxidizing power of ozone water itself is also added, and there is a possibility that the treatment liquid has stronger oxidizing power.

In addition, the electrolytic sulfuric acid contains both the persulfuric acid and the Caro's acid, and thus, the treatment liquid can exhibit high oxidizing power as compared with the substrate treatment using the Caro's acid alone at the same temperature.

The treatment liquid discharged to the substrate W and used for the substrate treatment flows as a treated liquid into the waste liquid pipe 122 through the valve 122A in the open state. The treated liquid contains sulfate ions (SO₄²⁻). Then, the treated liquid joins the collection pipe 124 and is collected in the collection tank 30.

The electrolytic sulfuric acid can be used again for substrate treatment by being collected and electrolyzed again. Thus, by performing the substrate treatment using the treatment liquid containing the electrolytic sulfuric acid, the waste liquid in association with the substrate treatment can be reduced.

The treated liquid stored in the collection tank 30 can be selectively (that is, to one or both) fed to the generation tank 20A by opening the valve 126A and to the generation tank 20B by opening the valve 126B via the collection pipe 126 by the pump 136.

### <Effects Obtained by Embodiments Described Above>

Next, an example of effects obtained by the embodiments described above will be described. Note that, in the following description, the effects will be described based on the specific configurations exemplified in the embodiments described above, but may be replaced with other specific configurations exemplified in the present specification as long as similar effects are obtained. In other words, in the following description, for convenience, only one of the associated specific configurations may be described as a representative, but the specific configuration described as a representative may be replaced with another specific configuration associated.

According to the embodiment described above, the substrate treatment device includes the substrate treatment unit, the supply tank 10, the temperature increasing unit, the generation unit, and the collection unit. Here, the substrate treatment unit corresponds to, for example, the treatment unit 600 including the discharge nozzle 106B. Further, the temperature increasing unit corresponds to, for example, the mixing pipe 200 for mixing the imparted water. Further, the generation unit corresponds to, for example, the generation tank 20A (or the generation tank 20B) connected to the electrolytic cell. Yet further, the collection unit corresponds to, for example, the collection pipe 124 connected to the collection tank 30. The substrate treatment unit treats the substrate W using a treatment liquid containing electrolytic sulfuric acid. The supply tank 10 stores a treatment liquid to be supplied to the substrate treatment unit. The mixing pipe 200 mixes imparted water with the treatment liquid supplied from the supply tank 10 in the substrate treatment unit. By this means, the mixing pipe 200 increases the temperature of the treatment liquid. The generation unit generates a treatment liquid by electrolysis in the electrolytic cell. Then, the generation unit supplies the generated treatment liquid from the generation tank to the supply tank 10. The collection pipe 124 collects a treated liquid, which is a treatment liquid used in the substrate treatment unit, and supplies the treated liquid to the generation unit.

According to such a configuration, by increasing the temperature of the electrolytic sulfuric acid contained in the treatment liquid immediately before being used for the substrate treatment in the treatment unit 600, the substrate treatment can be performed while suppressing decrease in oxidizing power of the electrolytic sulfuric acid.

Note that, even in a case where another component exemplified in the present specification is appropriately added to the above components, that is, even in a case where another component not mentioned as the above components in the present specification is appropriately added, a similar effect can be obtained.

According to the embodiment described above, the substrate treatment device includes a first circulation path for returning the treatment liquid supplied from the supply tank 10 to the supply tank 10. Here, the first circulation path corresponds to, for example, the circulation pipe 102. The substrate treatment unit includes the discharge nozzle 106B for discharging the treatment liquid branched and supplied from the circulation pipe 102 to the substrate W. The discharge nozzle 106B includes a discharge path for discharging the supplied treatment liquid to the substrate W, and a second circulation path that branches from the discharge path and returns the treatment liquid to the supply tank 10. Here, the discharge path corresponds to, for example, the flow path 35a, the flow path 35c, and the like, corresponding to part of the supply pipe 106 in the discharge nozzle 106B. The second circulation path corresponds to, for example, the flow path 35b corresponding to part of the return pipe 108 in the discharge nozzle 106B. Then, the mixing pipe 200 mixes the imparted water with the treatment liquid at the downstream of a point (for example, the valve chamber 40A in FIG. 4) at which the second circulation path branches, in the discharge path. According to such a configuration, by increasing the temperature of the electrolytic sulfuric acid downstream of the valve chamber 40A in the discharge nozzle 106B, a period during which the electrolytic sulfuric acid is maintained at equal to or lower than 60°C is lengthened, and the substrate treatment can be performed while suppressing decrease in oxidizing power of the electrolytic sulfuric acid.

Further, according to the embodiment described above, the circulation pipe 102 includes a second temperature adjustment unit for adjusting the temperature of the treatment liquid to the electrolysis temperature (for example, equal to or lower than 60°C) which is the temperature for generating the treatment liquid by electrolysis. Here, the second temperature adjustment unit corresponds to, for example, the heater 116. According to such a configuration, autolysis of the electrolytic sulfuric acid can be suppressed by adjusting the temperature of the treatment liquid to the electrolysis temperature (equal to or lower than 60°C) in the supply tank 10.

According to the embodiment described above, the generation unit includes a first electrolytic unit and a second electrolytic unit for generating a treatment liquid by electrolysis. Here, the first electrolytic unit corresponds to, for example, the electrolytic cell 21A. Further, the second electrolytic unit corresponds to, for example, the electrolytic cell 21B. While the electrolytic cell 21A supplies the treatment liquid to the supply tank 10, the electrolytic cell 21B electrolyzes the treated liquid collected by the collection pipe 124 to generate the treatment liquid. According to such a configuration, even while the treatment liquid is being generated in one generation tank (electrolytic cell), the treatment liquid can be continuously supplied from the other generation tank.

Further, according to the embodiment described above, the generation unit includes the first temperature adjustment unit for adjusting the temperature of the treated liquid and the temperature of the generated treatment liquid to the electrolysis temperature (for example, equal to or lower than 60°C) which is the temperature for generating the treatment liquid by electrolysis. Here, the first temperature adjustment unit corresponds to, for example, the heater 142 or the heater 150. According to such a configuration, it is possible to increase the generation rate of electrolytic sulfuric acid in a case where sulfuric acid is electrolyzed by adjusting the temperature of the treatment liquid to the electrolysis temperature (equal to or lower than 60°C) in the generation tank and the electrolytic cell. In addition, autolysis of the electrolytic sulfuric acid can be suppressed.

In addition, according to the embodiment described above, the generation unit includes a first replenishing unit for replenishing imparted water to the treatment liquid to be electrolyzed and a second replenishing unit for replenishing sulfuric acid to the treatment liquid to be electrolyzed. Here, the first replenishing unit corresponds to, for example, the pure water supply source 14. In addition, the second replenishing unit corresponds to, for example, the sulfuric acid supply source 16. According to such a configuration, in a case where the concentration of electrolytic sulfuric acid becomes higher than desired concentration, pure water, or the like, can be added to decrease the concentration, and in a case where the concentration of electrolytic sulfuric acid becomes lower than the desired concentration, sulfuric acid can be added to increase the concentration.

According to the embodiment described above, in the substrate treatment method, the treatment liquid to be supplied to the substrate treatment unit is stored in the supply tank 10. Then, in the substrate treatment unit, the temperature of the treatment liquid is increased by mixing imparted water with the treatment liquid supplied from the supply tank 10. Then, the substrate W is treated using the treatment liquid. Then, the treated liquid, which is the treatment liquid used in the substrate treatment unit, is collected and supplied to the generation unit. Then, a treatment liquid is generated from the liquid containing the treated liquid by electrolysis in the generation unit, and the generated treatment liquid is supplied to the supply tank 10.

According to such a configuration, by increasing the temperature of the electrolytic sulfuric acid contained in the treatment liquid immediately before being used for the substrate treatment in the treatment unit 600, the substrate treatment can be performed while suppressing decrease in oxidizing power of the electrolytic sulfuric acid.

Note that, in a case where there is no particular limitation, the order in which each treatment is performed can be changed.

In addition, even in a case where another component exemplified in the present specification is appropriately added to the above components, that is, even in a case where another component not mentioned as the above components in the present specification is appropriately added, the same effect can be obtained.

### <Modifications of Embodiments Described Above>

In the embodiments described above, a material, a dimension, a shape, a relative arrangement relationship, an implementation condition, or the like, of each component may also be described, but these are one example in all aspects and are not restrictive.

Thus, innumerable modifications and equivalents in which no examples are indicated are assumed within the scope of the technology disclosed in the present specification. For example, a case where at least one component is modified includes a case where the component is added or omitted.

In addition, in at least one embodiment described above, in a case where a material name, or the like, is described without being particularly specified, unless inconsistency arises, the material includes other additives, for example, an alloy, or the like.

### EXPLANATION OF REFERENCE SIGNS

1: substrate treatment device
10: supply tank
106B: discharge nozzle

## Claims

1. A substrate treatment device comprising:
a substrate treatment unit that treats a substrate using a treatment liquid containing electrolytic sulfuric acid;
a supply tank that stores said treatment liquid to be supplied to said substrate treatment unit;
a temperature increasing unit that increases a temperature of said treatment liquid by mixing imparted water with said treatment liquid supplied from said supply tank in said substrate treatment unit;
a generation unit that generates said treatment liquid by electrolysis and supplies said generated treatment liquid to said supply tank; and
a collection unit that collects a treated liquid that is said treatment liquid used in said substrate treatment unit and supplies the treated liquid to said generation unit.

2. The substrate treatment device according to claim 1, further comprising
a first circulation path that returns, to said supply tank, said treatment liquid supplied from said supply tank, wherein
said substrate treatment unit includes a discharge nozzle that discharges said treatment liquid branched and supplied from said first circulation path to said substrate,
said discharge nozzle includes a discharge path that discharges said treatment liquid supplied to said substrate, and a second circulation path that branches from said discharge path and returns said treatment liquid to said supply tank, and
said temperature increasing unit mixes said imparted water with said treatment liquid on a downstream side of a point at which said second circulation path branches, in said discharge path.

3. The substrate treatment device according to claim 2, further comprising a second temperature adjustment unit that adjusts the temperature of said treatment liquid to an electrolysis temperature that is a temperature for generating said treatment liquid by electrolysis in said first circulation path.

4. The substrate treatment device according to any one of claims 1 to 3, wherein
said generation unit includes a first electrolytic unit and a second electrolytic unit that generate said treatment liquid by electrolysis, and
while said first electrolytic unit supplies said treatment liquid to said supply tank, said second electrolytic unit electrolyzes said treated liquid collected by said collection unit to generate said treatment liquid.

5. The substrate treatment device according to any one of claims 1 to 4, wherein said generation unit includes a first temperature adjustment unit that adjusts the temperature of said treated liquid and a temperature of the generated treatment liquid to an electrolysis temperature that is a temperature for generating said treatment liquid by electrolysis.

6. The substrate treatment device according to any one of claims 1 to 5, wherein
said generation unit comprises:
a first replenishing unit that replenishes said treatment liquid to be electrolyzed with said imparted water; and
a second replenishing unit that replenishes said treatment liquid to be electrolyzed with sulfuric acid.

7. A substrate treatment method for treating a substrate using a treatment liquid containing electrolytic sulfuric acid, the substrate treatment method comprising:
a step of storing said treatment liquid to be supplied to a substrate treatment unit in a supply tank;
a step of increasing a temperature of said treatment liquid by mixing imparted water with said treatment liquid supplied from said supply tank in said substrate treatment unit;
a step of treating said substrate using said treatment liquid mixed with said imparted water in said substrate treatment unit;
a step of collecting a treated liquid which is said treatment liquid used for treatment in said substrate treatment unit, and supplying the treated liquid to a generation unit; and
a step of generating said treatment liquid from a liquid containing said treated liquid by electrolysis in said generation unit and supplying the generated treatment liquid to said supply tank.
